# EUROPEAN PATENT APPLICATION

(11) **EP 2 871 675 A1**
(43) Date of publication of application: **13.05.2015**
(21) Application number: 13191723.9
(22) Date of filing: 06.11.2013
(51) Int. Cl.: H01L 23/48, H01L 21/60

(54) **Pressure connection for a semiconductor die using flexible nanowires and corresponding manufacturing method**

(71) Applicant: Mitsubishi Electric R & D Centre Europe B.V., 1119 NS Schiphol Rijk (NL); Mitsubishi Electric Corporation, Chiyoda-ku Tokyo 100-8310 (JP)
(72) Inventor: Mollov, Stefan, 35708 Rennes Cedex 7 (FR); Ewanchuk, Jeffrey, 35708 Rennes Cedex 7 (FR)
(74) Representative: Maillet, Alain

(57) **Abstract**

The present invention concerns a semiconductor die (12, 30) comprising at least two metallic pads (10) that are electrically connected to said die (12, 30), wherein each pad (10) has on its surface a plurality of nanowires (15, 31) made of metal, alloy or polymer disposed orthogonally on the surface of the pad (10), the nanowires of each pad (10) being in contact with an electrically conducting element such as a part of a press pack casing (33), the electrically conducting element and the pad (10) performing a pressure in the axial direction of the nanowires (15, 31), each nanowire (15, 31) having a ratio height to width which makes the nanowire (15, 31) flexible when subject to a pressure in the axial direction of the nanowire (15, 31). The pads (10) and the nanowires (15, 31) form also a thermal connection used for conducting thermal energy away from the die (12, 30). The nanowires (15, 31) are formed by forming an oxide layer on the surface of each pad (10), the oxide layer comprising pores, filling the pores using a metallisation process, optionally polishing the surface of the oxide layer and etching the oxide layer in order to free the nanowires (15, 31).

## Description

The present invention relates generally to a semiconductor die and a die assembly, comprising at least two pads that are electrically connected to said die.

A typical power die is electrically connected to the external components via wire bonds and soldering and a thermally conductive substrate for heat transport. A number of layers is necessary to enable the cabling of the wire bonds on the die including, for example, an Aluminum metallization layer, a solder layer, and a passivation layer. In addition, due to the number of layers and differing mechanical properties of these layers, these components typically feature heavily in the reliability of the die.

More particularly, power dies are subject to strong thermal and associated mechanical constraints.

All parts used to electric conduction and/or thermal conduction are therefore exposed to constant stress and experience considerable mechanical forces. This is the principal failure mechanism of all power dies at present, manifested at the entire range of thermo-electrical interfaces as delamination, wire lifting and cracks.

Furthermore, in the process involving chip embedding and lamination such as in Integrated Power Boards, the roughness of the interfaces is important for current adhesion techniques. The die metallisation is a lot more polished than the complementary surfaces, thus a relatively complex process is needed to facilitate the interface in the form of a micrometer-thin metal film addition and adhesion.

Finally, the adherence of power die to supporting interface is done principally by soldering, wire bonding, diffusion soldering or sintering with various degrees of compromised reliability due to the reasons explained above. The adhesion processes are relatively aggressive with regards to the power die and may consume some of the die lifetime during manufacture. Also, the process profiles can be energy and time consuming, whereby the process cost is increased.

The present invention aims at improving the reliability of the die. The present invention aims to incorporate a practical methodology for manufacturing an alternative die-attach technique without requiring any special preparation for the power die.

To that end, the present invention concerns a semiconductor die, comprising at least two metallic pads that are electrically connected to said die, **characterized in that** each pad has on its surface a plurality of nanowires disposed orthogonally on the surface of the pad, each nanowire having a ratio height to width which makes the nanowire flexible when subject to a pressure in the axial direction of the nanowire.

Thus, the nanowires can follow different dilations of material with which they are in contact without degrading the conductivity of the connection.

According to a particular feature, the height is at least 5 times the nanowire width.

Thus, by using electric conducting nanowires having a height which is at least 5 times the nanowire width, the nanowires are flexible and can follow different dilations of interface materials with which they are in contact without degrading the conductivity of the connection.

Such technique of connection is much more easy to realise and increases a lot the lifetime of die and the packaging assembly.

A nanowire is a structure that has at least one dimension below 1um. Alternatively, nanowires can be defined as structures that have a thickness or diameter constrained to tens of nanometers or less and an unconstrained length.

According to a particular feature, the pads and the nanowires form a thermal connection used for conducting the thermal energy away from the die.

Thus, by using electric conducting nanowires having a height which is at least 5 times the nanowire width, the nanowires are flexible and can follow different dilations of material with which they are in contact and enable a good thermal transfer.

According to a particular feature, the nanowires are composed of metal, alloy or polymere.

Thus, as metal and metal alloys have good electrical and thermal conductivity, the lifetime of the semiconductor die is improved. Polymeres could provide more flexible interface while trading for electrical and thermal conductivity, though overall interface robustness is improved.

According to a particular feature, the metal is copper and/or gold and/or aluminium.

Thus, as metal has good electrical and thermal conductivity, the lifetime of the semiconductor die is improved.

According to a particular feature, the nanowires cover between 70 and 95 percent of the metallic pad surface.

Thus, as occupation is increased, thermal and electric transport is increased while the interface remains mechanically flexible. The immediate die metallisation remains relatively thin which is of particular interest to thin-wafer processing for reduced die deformation.

According to a particular feature, the nanowires of each pad are in contact with an electrically conducting element, the electrically conducting element and the pad performing a pressure in the axial direction of the nanowires.

Thus, the vertical and lateral mechanical stress due to thermal dilation is absorbed while thermal and electrical transport is maintained.

According to a particular feature, the electrically conducting elements are parts of a press pack casing.

Thus, the well known advantages of press-pack, like fault modes, low parasitics etc can be integrated in the proposed assembly, while the associated cost is reduced by negating the need for specific dilation interfaces.

The present invention concerns also a method for manufacturing a semiconductor die comprising at least two pads of a metallic layer that are electrically connected to said die, **characterized in that** the method comprises the steps of :
- forming a oxide layer on the surface of each pad, the oxide layer comprising pores,
- filling the pores using a metallization process,
- etching the oxide layer in order to free the nanowires.

Thus, by using electric conducting nanowires, the nanowires are flexible and can follow different dilations of material with which they are in contact without degrading the conductivity of the connection.

According to a particular feature, the method comprises the step, executed prior to the etching of the oxide layer, of polishing the surface of the oxide layer the pores of which are filled.

Thus, the nanowires have almost the same height.

According to a particular feature, the method comprises the steps of :
- putting the obtained nanowires of each pad in contact with an electrically conducting element,
- applying between the electrically conducting element and the pad a pressure in the axial direction of the nanowires.

The characteristics of the invention will emerge more clearly from a reading of the following description of an example embodiment, the said description being produced with reference to the accompanying drawings, among which :
Fig. 1 represents a view of a metallic pad that is electrically connected to at least one die the pad having on its surface a plurality of electrically conducting nanowires disposed orthogonally on the surface of the pad;
Fig. 2 represents a die having a plurality of metallic pads, each pad having on its surface a plurality of electrically conducting nanowires disposed orthogonally on the surface of the pad and wherein a patterning has been performed post nanowire formation;
Fig. 3 represents an example of a press pack casing comprising a die, metallic pads having on their surface a plurality of electrically conducting nanowires disposed orthogonally on the surface of the pad;
Fig. 4 represents an example of a sequence for manufacturing a semiconductor die comprising at least one die and at least two pads of a metallic layer that are electrically connected to said at least one die.

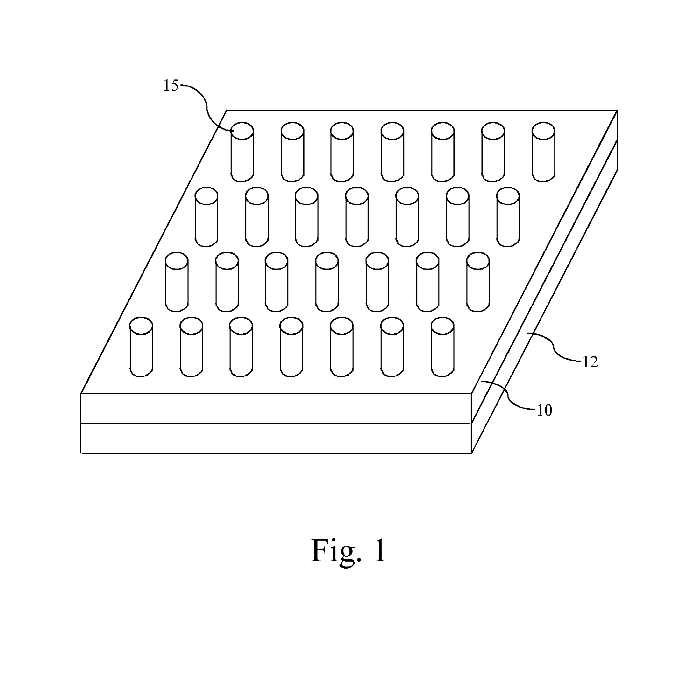

**Fig. 1** represents a view of a metallic pad that is electrically connected to at least one die, the pad having on its surface a plurality of electrically conducting nanowires disposed orthogonally on the surface of the pad.

The metallic pad 10 is deposited on a die 12 and has on its surface a plurality of electrically conducting nanowires 15 disposed orthogonally on the surface of the pad 10.

Each nanowire 15 has a ratio height by width which makes the nanowire flexible when subject to a pressure in the axial direction of the nanowire.

More particularly, each nanowire 15 has a height which is at least 5 times the nanowire width. The height may be up to 100 times the nanowire width.

The nanowires 15 are composed of metal like copper or gold or aluminium or other alloys or are composed of polymere material.

The nanowires 15 cover between 70 and 95 percent of the metallic pad surface.

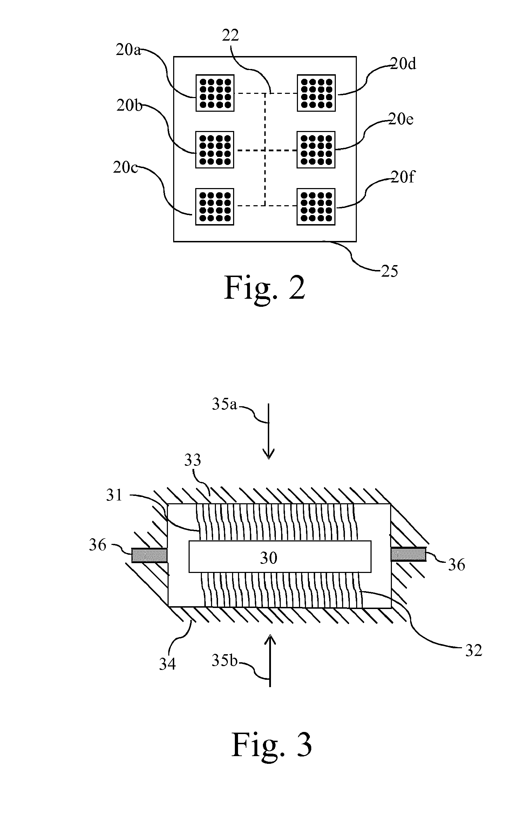

**Fig. 2** represents a die having a plurality of metallic pads, each pad having on its surface a plurality of electrically conducting nanowires disposed orthogonally on the surface of the pad.

The die 25 has a plurality of metallic pads 20a to 20f, each pad 20a to 20f has on its surface a plurality of electrically conducting nanowires disposed orthogonally on the surface of the pad.

In the example of Fig. 2, a patterning is performed post nanowire formation in order to obtain inter-pad bridges.

Fig. **3** represents an example of a press pack casing comprising a die, metallic pads having on their surface a plurality of electrically conducting nanowires disposed orthogonally on the surface of the pad.

The press pack casing is composed of two parts 33 and 34. For example, parts 33 and 34 are metallic parts, separated by electric isolation material 36. The die 30 has on upper side and lower side metallic pads having on their surface a plurality of electrically conducting nanowires 31 and 32 disposed orthogonally on the surface of the pad.

The arrows 35a and 35b show the direction of the pressure which is performed on the parts 33 and 34 which put into contact the nanowires 31 and the part 33 and put into contact the nanowires 32 and the part 34.

If at least one of the part 33 and/or 34 dilates relative to the die 30, the nanowires 31 and/or 32 absorb the deformation, be it in axial or lateral direction, caused by dilatation ensuring then a good electric contact and a good thermal contact.

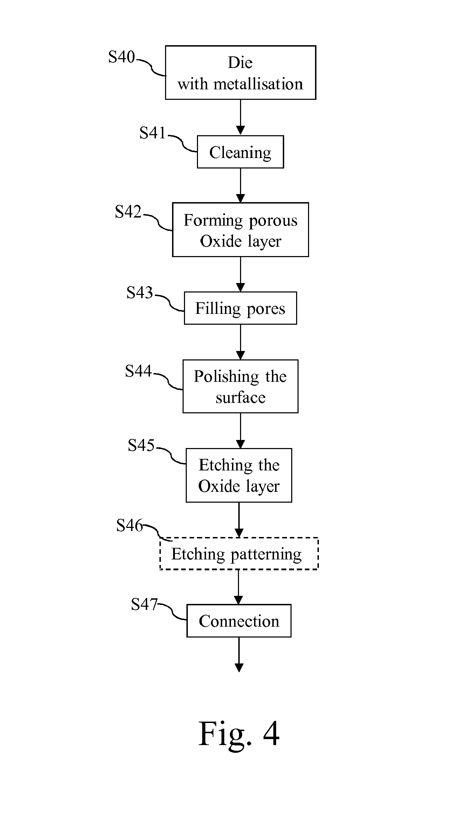

**Fig. 4** represents an example of a sequence for manufacturing a semiconductor die comprising at least one die and at least two pads of a metallic layer that are electrically connected to said at least one die.

At step S40, a die with a metallic layer is obtained. Metallic layers are pads.

At next step S41, the metallic layer is first cleaned and/or degreased, for example by acetone and electro polishing.

At next step S42, an oxide layer is formed on the surface of each pad, the oxide layer comprising pores. For example, the metallic layer is anodized, forming a layer with irregular porosity. Optionally, a further step might be used then to regularize the pores, using a second anodisation process, resulting in the regular anodized porous oxide layer. We now have a supporting matrix for the formation of the plurality of nanowires, named nanoforest.

At next step S43, the pores are filled using a metallization process. For example, an electro deposition process is used after the porous oxide layer is created to begin the formation of the metallized nanowires, whereby the pores with diameter of up to 1µm are being filled up with metal from the electro-deposition solution.

At an optional step S44, the surface of die is then polished.

At step S45, the oxide layer is etched in order to free the nanowires.

If a standard electro-deposition process has been used for filling up the pores, an intermediate S46 step is necessary, the step S46 consists in removing the inter-pad bridges.

At step S47, the pads with nanowires are connected to a substrate or a case. For example, the obtained nanowires of each pad are put in contact with an electrically conducting element like a case shown in Fig. 3 and a pressure in the axial direction of the nanowires is performed with the electrically conducting element and the pad.

Naturally, many modifications can be made to the embodiments of the invention described above without departing from the scope of the present invention.

## Claims

1. A semiconductor die, comprising at least two metallic pads that are electrically connected to said die, **characterized in that** each pad has on its surface a plurality of nanowires disposed orthogonally on the surface of the pad, each nanowire having a ratio height to width which makes the nanowire flexible when subject to a pressure in the axial direction of the nanowire.

2. The semiconductor die according to claim 1, **characterized in that** the height is at least 5 times the nanowire width.

3. The semiconductor die according to claim 1 or 2, **characterized in that** the pads and the nanowires form an thermal connection used for conducting the thermal energy away from the die.

4. The semiconductor die according to any of the claims 1 to 3, **characterized in that** the nanowires are composed of metal, alloy or polymere.

5. The semiconductor die according to claim 4, **characterized in that** the metal is copper and/or gold and/or aluminium.

6. The semiconductor die according to any of the claims 1 to 5, **characterized in that** the nanowires cover between 70 and 95 percent of the metallic pad surface.

7. The semiconductor die according to any of the claims 1 to 6, **characterized in that** the nanowires of each pad are in contact with an electrically conducting element, the electrically conducting element and the pad performing a pressure in the axial direction of the nanowires.

8. The semiconductor die according to claim 7, **characterized in that** the electrically conducting elements are parts of a press pack casing.

9. Method for manufacturing a semiconductor die comprising at least two pads of a metallic layer that are electrically connected to said die, **characterized in that** the method comprises the steps of :
- forming an oxide layer on the surface of each pad, the oxide layer comprising pores,
- filling the pores using a metallization process,
- etching the oxide layer in order to free the nanowires.

10. Method according to claim 9, **characterized in that** the method comprises the step, executed prior to the etching of the oxide layer, of polishing the surface of the oxide layer the pores of which are filled.

11. Method according to claim 9 or 10, **characterized in that** the method comprises the steps of:
- putting the obtained nanowires of each pad in contact with an electrically conducting element,
- applying between the electrically conducting element and the pad a pressure in the axial direction of the nanowires.
